# EUROPÄISCHE PATENTANMELDUNG

(11) **EP 2 346 091 A2**
(43) Veröffentlichungstag der Anmeldung: **20.07.2011**
(21) Anmeldenummer: 11151233.1
(22) Anmeldetag: 18.01.2011
(51) Int. Cl.: H01L 31/048, H01L 31/02

(54) **Anschlusseinheit für Photovoltaische Module**

(30) Priorität: 19.01.2010 DE 102010001016
(71) Anmelder: SCHOTT Solar AG, 55122 Mainz (DE)
(72) Erfinder: Dr. Nattermann, Kurt, 55437 Ockenheim (DE); Prof. Dr. Schwirtlich, Ingo, 63897, Miltenberg (DE); Prof. Dr. Franke, Dieter, 6291, BL Vaals (NL)
(74) Vertreter: Hrovat, Andrea Darinka

(57) **Zusammenfassung**

Die vorliegende Erfindung betrifft ein Solarmodul zum Umwandeln von Strahlungsenergie, insbesondere Sonnenlicht, in elektrische Energie, umfassend eine Solarzelle (12) zum Umwandeln von Strahlungsenergie in elektrische Energie, einen elektrischen Leiter (24) zum Leiten der elektrischen Energie und eine die Solarzelle (12) umgebende Einkapselung (14) zum Schützen der Solarzelle (12), wobei die Einkapselung (14) eine oder mehrere Glasscheiben (16) zum Schützen und Stabilisieren der Solarzelle (12), eine Schicht (22) aus Einbettungsmaterial, in das die Solarzelle (12) einlaminiert oder eingegossen ist, sowie einen in die Glasscheibe (16) eingeschmolzenen Körper (26) zum Leiten der elektrischen Energie oder zum Durchführen des elektrischen Leiters (24) durch die Glasscheibe (16) umfasst. Ferner betrifft die Erfindung ein Verfahren zum Einschmelzen des Körpers (26) in eine Glasscheibe (16) eines Solarmoduls.

## Beschreibung

Die vorliegende Erfindung betrifft ein Solarmodul zum Umwandeln von Strahlungsenergie, insbesondere von Sonnenlicht, in elektrische Energie, umfassend eine Solarzelle zum Umwandeln von Strahlungsenergie in elektrische Energie, einen elektrischen Leiter zum Leiten der elektrischen Energie und eine die Solarzelle umgebende Einkapselung zum Schützen der Solarzelle, wobei die Einkapselung eine oder mehrere Glasscheiben zum Schützen und Stabilisieren der Solarzelle und eine Schicht aus Einbettungsmaterial, in das die Solarzelle einlaminiert oder eingegossen ist, umfasst. Weiterhin betrifft die Erfindung ein Verfahren zum Herstellen eines entsprechenden Solarmoduls.

Um Solarzellen möglichst effizient betreiben zu können, müssen sie möglichst lange dem Sonnenlicht ausgesetzt werden, weshalb sie im Freien und ohne Abschattungen, beispielsweise von Gebäuden oder Bäumen, installiert werden. Dort sind sie allerdings einer Vielzahl von äußeren Einflüssen ausgesetzt, wie beispielsweise Schmutzpartikeln, Hagel, Temperaturschwankungen und korrosiven Medien. Ferner können die Solarzellen bei der Montage oder bei der Wartung beschädigt werden. Sie werden daher eingekapselt, um sie vor diesen Einflüssen zu schützen und um die elektrische Sicherheit zu gewährleisten. Die wesentlichen Komponenten einer Einkapselung sind neben der Glasscheibe, die in Richtung der einfallenden Strahlen vor der Solarzelle angeordnet ist, und der Schicht aus Einbettungsmaterial eine Folie auf der Rückseite der Solarzelle, die alternativ auch durch eine weitere Glasscheibe ersetzt werden kann. Das Einbettungsmaterial ist ein transparenter Kunststoff, beispielsweise Ethylenvinylacetat (EVA) oder Silikongummi.

Die Solarzellen und die Einkapselung bilden einen Teil eines Solarmoduls, welches weiterhin üblicherweise eine Anschlussdose sowie Profil-Rahmen, beispielsweise aus Aluminium, Stahl oder faserverstärktem Kunststoff, zum Schützen der Glasscheibe beim Transport, Handhabung und Montage und zum Befestigen und Versteifen des Solarmoduls umfasst.

Die in einem Solarmodul verwendeten Glasscheiben sind üblicherweise aus Natron-Silikat-Gläser, die eine Dicke von mehreren Millimetern aufweisen, um dem Solarmodul die erforderliche Steifigkeit zu verleihen. Die Glasscheiben können mit einer Antireflexionsschicht versehen sein, um zu vermeiden, dass sich die Sonne in den Solarmodulen spiegelt, was Irritationen beispielsweise für Flugzeuge hervorrufen könnte.

Als Ausgangsmaterial von Solarzellen wird in den meisten Fällen Silizium verwendet, welches hauptsächlich in zwei verschiedenen Konfigurationen Verwendung findet: Zum einen wird kristallines Silizium (c-Si) und zum anderen amorphes Silizium (a-Si) verwendet.

Am ergiebigsten ist das nach dem Czochralski-Verfahren "gezogene" monokristalline Silizium, das Wirkungsgrade von 12 bis 15% ermöglicht. Bei diesem Verfahren ist jedoch höchste Reinheit erforderlich, was die Herstellung sehr teuer macht. In jedem Fall unverzichtbar ist dieses Material für Transistoren, integrierte Schaltkreise und ähnliche Anwendungen. Für Solarzellen eignet sich dagegen auch das billiger herstellbare polykristalline Silizium, das in Blöcken gegossen wird und mit dem sich Wirkungsgrade von 10 bis 13% erzielen lassen.

Monokristalline und polykristalline Solarzellen haben in der Regel ein quadratisches Format mit einer Größe von ca. 15 x 15 cm. Sie werden mit Spezialsägen von den gezogenen oder gegossenen Silizium-Blöcken abgesägt. Monokristalline Silizium-Solarzellen erkennt man an ihrer gleichmäßigen, glatten Oberfläche sowie den gebrochenen Ecken, die auf das Herstellungsverfahren zurückzuführen sind. Sie werden nämlich aus runden Scheiben herausgesägt, die ihre runde Gestalt wiederum den nach dem Czochralski-Verfahren gezogenen Blöcken verdanken.

Polykristalline Solarzellen sind dagegen so quadratisch wie die gegossenen Blöcke, aus denen sie herausgesägt werden. Sie haben eine unregelmäßige Oberfläche, auf der deutlich die Kristallite von einigen Millimetern bis einigen Zentimetern Durchmesser zu sehen sind.

Die technisch mögliche Dicke dieser gesägten Scheiben, beträgt üblicherweise ca. 0,2 mm. Entscheidend für die Menge der aus der Strahlungsenergie umgewandelten elektrischen Energie ist nämlich die Fläche der Solarzelle und nicht deren Dicke, so dass die Möglichkeit, dünnere Scheiben herzustellen, einen Kostenvorteil bringt, da sich damit aus demselben Silizium-Block weitaus mehr Scheiben gewinnen lassen.

Amorphes Silizium weist keine Kristallstruktur auf, sondern besteht aus ungeordneten Silizium-Atomen, die auf Glas oder ein anderes Substrat aufgedampft werden. Amorphes Silizium verfügt über ein hohes Absorptionsvermögen und kann daher bei Solarzellen mit besonders geringen Schichtdicken verwendet werden. Die üblichen Schichtdicken sind dabei etwa um einen Faktor 100 kleiner als bei kristallinem Silizium. Dies gleicht den durch die Defekte geringen Wirkungsgrad von etwa 6 bis 8% aus und macht amorphes Silizium aus wirtschaftlicher Sicht für Anwendungen in der Solarindustrie interessant.

Um elektrische Leitungen zu den Solarzellen zu führen und die von ihnen bereitgestellte elektrische Energie abnehmen zu können, müssen elektrische Leiter im Solarmodul verlegt werden. Hierzu ist es beispielsweise aus der DE 102 25 140 A1 bekannt, an bestimmten Stellen der Rückseite des Solarmoduls Löcher in die Glasscheibe zu bohren. Für den Fall, dass die Rückseite mit Folie gebildet wird, werden die Löcher nicht gebohrt, sondern in die Folie gestanzt. Der elektrische Leiter kann durch diese Löcher aus dem Solarmodul geführt und an externe Schaltkreise angeschlossen werden.

Die Leiter können beispielsweise in Form von Lötbändern ausgeführt sein, über welche die Solarzellen oder ganze Solarmodule miteinander verschaltet sind. Üblicherweise werden meistens 8 bis 12 in Reihe geschaltete Solarzellen zu einem String zusammengefasst. Weiterhin werden die Lötbänder üblicherweise U-förmig verlegt, so dass zwei nebeneinander liegende Strings zu einer Einheit zusammengefasst werden. Zu jedem String wird dann eine Diode geschaltet, die im normalen Betriebszustand (Solarzelle liefert Strom) in Sperrrichtung gepolt ist. Wenn eine Solarzelle durch Abschattung oder durch einen Defekt keinen Strom liefert, würden die nunmehr in Sperrrichtung betriebenen Dioden einen String, welcher aus mehreren in Reihe geschalteten Solarzellen besteht, außer Betrieb nehmen. Überschreitet die Spannung der in Reihe geschalteten funktionstüchtigen und bestrahlten Solarzellen die Sperrspannung der nicht bestrahlten Solarzelle, kann diese sogar zerstört werden. Dies wird durch die Dioden verhindert. Ein String kann daher auch in diesem Fall elektrische Energie liefern, wenn auch in geringerem Umfang.

In der DE 761 322 ist ein Elektrodensystem in einem Kolben angeordnet, der auf einem Pressglasfuß steht. Zwei elektrische Leiter sind dabei durch den Pressglasfuß geführt. Die Stelle der Durchführung wird dabei mit Glaslot verschlossen. Die DE 761 322 betrifft keine Solarmodule.

Die DE 30 47 399 A1 betrifft ein Verfahren zur mechanischen und elektrischen Verbindung gekapselter Solarzellen-Generatoren mit äußeren Anschlussleitern. Hierbei geht es darum, eine leitende Verbindung durch das Einkapselungsmaterial anzugeben, so dass die von einer Solarzelle bereitgestellte elektrische Energie über ein Anschlusselement auf ein Kabel übertragen und weitergeleitet werden kann. Die in der DE 30 47 399 A1 offenbarte Erfindung betrifft keine Durchführung durch Glasscheiben.

Für den Fall, dass die Rückseite des Solarmoduls mit einer Glasscheibe gebildet wird, haben die gebohrten Löcher zum Durchführen der elektrischen Leiter den Nachteil, dass sie die Glasscheibe schwächen, wodurch ihre Festigkeit und ihre Tragfähigkeit vermindert werden. Sowohl bei der Ausgestaltung der Rückseite mit einer Glasscheibe als auch mit einer Folie tritt weiterhin der Nachteil auf, dass die Löcher den Eintritt von umgebenden Medien wie Staubpartikel, Feuchtigkeit und korrosiven Gasen wie Ammoniak bei Verwendung in viehwirtschaftlichen Anlagen ermöglichen, da die Löcher mit den Leitern nicht abdichten. Diese Medien können die Solarzellen schädigen und zu einer deutlichen Verminderung ihrer Lebensdauer führen.

Aufgabe der vorliegenden Erfindung ist es daher, Solarmodule der eingangs genannten Art so weiterzuentwickeln, dass die von den Solarzellen bereitgestellte elektrische Energie auf mechanisch zuverlässige und dauerhaft dichte Weise aus dem Solarmodul abgeführt werden kann, ohne den Herstellungsprozess des betreffenden Solarmoduls spürbar zu verkomplizieren.

Gelöst wird die Aufgabe durch einen in die Glasscheibe eingeschmolzenen Körper zum Leiten der elektrischen Energie durch die Glasscheibe oder zum Durchführen des elektrischen Leiters durch die Glasscheibe. Zwar wird die elektrische üblicherweise an der Rückseite aus dem Solarmodul abgeführt, jedoch ist es genauso möglich, dies an der Vorderseite des Solarmoduls zu tun. Der Körper kann daher sowohl in eine Glasscheibe an der Vorderseite als auch an der Rückseite des Moduls oder auch in beide Glasscheiben eingeschmolzen werden. Dadurch, dass der Körper in die Glasscheibe eingeschmolzen wird, wird sichergestellt, dass die Kontaktfläche zwischen der Glasscheibe und dem Körper dauerhaft abgedichtet ist, so dass hier keine Medien, insbesondere Flüssigkeiten und korrosive Gase in das Solarmodul eindringen können. Die Solarzellen sind daher vor diesen Medien geschützt, so dass sich ihre Lebensdauer verlängern lässt. Weiterhin bildet der Körper dadurch, dass er in die Glasscheibe eingeschmolzen wird, einen Verbund mit der Glasscheibe, so dass sie im Gegensatz zu gebohrten Löchern mechanisch nicht geschwächt wird. Die Festigkeit und die Tragfähigkeit der Glasscheibe werden nicht reduziert, so dass das Solarmodul insgesamt mechanisch stärker belastet werden kann. Ferner kann die Glasplatte vorgespannt sein, die dann erfindungsgemäß für die Fixierung des Körpers genutzt wird. Diese Vorspannung geht durch das erfindungsgemäße Einschmelzen des Körpers nicht verloren.

Vorzugsweise ist der Körper als ein elektrisch leitender Stift ausgeführt, der mit dem elektrischen Leiter leitend verbunden ist. Der Körper wird so in die Ableitung der elektrischen Energie aus dem Solarmodul eingebunden. Diese Ausführung ist fertigungstechnisch besonders einfach und damit kostengünstig realisierbar. Die elektrischen Leiter müssen nur noch an beiden Seiten des Körpers befestigt werden, beispielsweise durch Löten. Der Körper muss also aus elektrisch leitendem Material wie Metall bestehen, was allerdings sowieso ein weit verbreitetes Material für Stifte darstellt, so dass diese Einschränkung keinen technischen Nachteil mit sich bringt.

In einer bevorzugten Ausgestaltung ist der Stift als Zylinderstift, Kegelstift oder Bolzen mit Kopf ausgeführt. In diesen Ausgestaltungen können Normteile verwendet werden, die in großen Stückzahlen hergestellt werden und daher günstig verfügbar sind. Kegelstifte und Bolzen mit Kopf haben weiterhin den Vorteil, dass ihre Position zumindest in eine Richtung weitgehend festgelegt ist, so dass sie beim Einschmelzen besser in die gewünschte Position gebracht werden können. Ferner reduziert sich die Gefahr des Verrutschens beim Einschmelzen.

In einer vorteilhaften Ausgestaltung der vorliegenden Erfindung weist der Körper eine Durchgangsbohrung zum Durchführen des elektrischen Leiters durch den Körper und durch die Glasscheibe auf. Hier braucht der elektrische Leiter nicht elektrisch leitend mit dem Körper verbunden werden, so dass er durchgehend aus dem Solarmodul zu angrenzenden Schaltkreisen geführt werden kann.

In einer bevorzugten Ausführungsform des erfindungsgemäßen Solarmoduls umfasst der Körper ein Gewinde, in welches eine Schraube zum elektrisch leitenden Verbinden des elektrischen Leiters mit dem Körper einschraubbar ist. Auf diese Weise kann die elektrisch leitende Verbindung auf einfache Weise hergestellt werden, wobei sie gleichzeitig, beispielsweise im Vergleich zu Lötverbindungen, sehr fest ist. Vorzugsweise ist das Gewinde so ausgerichtet, dass die Schraube von der Vorderseite des Solarmoduls, also von der Richtung der einfallenden Strahlen, in das Gewinde einschraubbar ist. Dies hat den Vorteil, dass die Schraubverbindung gut zugänglich und sichtbar ist. Dadurch können die Montage vereinfacht und Fehler in der Verkabelung des Solarmoduls besser identifiziert und behoben werden.

Vorteilhafterweise weist das erfindungsgemäße Solarmodul eine weitere Einkapselung zum Schützen des elektrischen Leiters und Sichern der Schraube auf. Hierbei kann das Einkapselungsmaterial der weiteren Einkapselung demjenigen der Einkapselung entsprechen. Dabei ist die weitere Einkapselung so ausgestaltet, dass sie die Schraube und teilweise den elektrischen Leiter umschließt. Einerseits können der Körper, das Gewinde und die Schraube vor äußeren Einflüssen, insbesondere Witterungseinflüssen, geschützt werden, andererseits kann auch der elektrische Leiter vor mechanischen Einflüssen, wie Zugbelastungen, geschützt werden, wenn die weitere Einkapselung entsprechend ausgebildet wird. Weiterhin kann eine Lockerung der Schraube verhindert werden.

Vorzugsweise besteht der Körper aus nicht leitendem Material und weist eine Durchgangsbohrung zum Durchführen des elektrischen Leiters durch den Körper und durch die Glasscheibe auf. In dieser Ausgestaltung ist man frei in der Wahl des Materials, aus dem der Körper gefertigt ist. Hierbei können die Materialien beispielsweise so gewählt werden, dass deren thermischer Ausdehnungskoeffizient auf den des Glases angepasst werden kann. Dies kann beim Einschmelzungsprozess vorteilhaft genutzt werden, um gezielte Spannungen in der Glasscheibe zu induzieren, die den Körper sicher und dauerhaft in der Glasscheibe halten.

Ein weiterer Aspekt der Erfindung betrifft ein Verfahren zum Einschmelzen eines Körpers in eine Glasscheibe eines Solarmoduls nach einem der vorherigen Ausführungsbeispiele, wobei der Körper zum Durchführen eines elektrischen Leiters durch die Glasscheibe oder zum Leiten der elektrischen Energie durch die Glasscheibe dient, umfassend folgende Schritte:
- Erwärmen der Glasscheibe von einer ersten auf eine Temperatur, wobei die zweite Temperatur gleich oder größer als die Glasübergangstemperatur des verwendeten Glases ist,
- Durchführen des Körpers durch die Glasscheibe bei der zweiten Temperatur,
   und
- Abkühlen der Glasscheibe auf eine dritte Temperatur.

Die Glasübergangs oder Erweichungstemperatur T_{G} trennt den unterhalb liegenden spröden energieelastischen Bereich vom oberhalb liegenden weichen entropieelastischen Bereich des betreffenden Glases. In diesem weichen Bereich kann der Körper mit relativ geringem Kraftaufwand durch die Glasscheibe geführt werden, ohne dass die Glasscheibe beschädigt wird, insbesondere, ohne dass sie bricht. Der Körper kann unter Zuhilfenahme eines geeigneten Werkzeuges durch die erwärmte Glasscheibe durchgeführt werden. Die zweite Temperatur kann deutlich über der Glasübergangstemperatur liegen, allerdings muss darauf geachtet werden, dass sie nicht so hoch ist, dass das Glas nicht dauerhaft verändert wird, beispielsweise durch Entmischung, Entglasung oder Abdampfen. Üblicherweise ist die erste Temperatur die Raumtemperatur, allerdings ist es ebenfalls möglich, eine andere Temperatur zu wählen, von der aus die Glasscheibe auf die zweite Temperatur erwärmt wird. Auch die dritte Temperatur ist üblicherweise die Raumtemperatur, so dass die erste Temperatur gleich der dritten sein kann, aber nicht muss. Es kann vorteilhaft sein, die

Glasscheibe zunächst auf eine von der Raumtemperatur abweichende Temperatur abzukühlen und dort für einige Zeit zu halten, bevor sie sich dann der Raumtemperatur anpassen kann.

Das erfindungsgemäße Verfahren wird dadurch weitergebildet, dass die Glasscheibe in einem Durchführbereich erwärmt wird, innerhalb dessen der Körper durch die Glasscheibe durchgeführt wird. Unter Durchführbereich soll ein Bereich verstanden werden, der die Stelle, an welcher der Körper durch die Glasscheibe geführt wird, umgibt. Eine genaue räumliche Eingrenzung des Durchführbereichs soll hier nicht erfolgen, da seine räumliche Ausbreitung von vielen Faktoren wie dem verwendeten Glas und/oder der Höhe der zweiten Temperatur abhängt. Es kann allerdings gesagt werden, dass sich vorzugsweise das Zentrum des Durchführbereichs in etwa an der Längsachse des Körpers befindet.

Die Erwärmung nur dieses Durchführbereichs hat den Vorteil, dass nicht die gesamte Glasscheibe erwärmt werden muss, was energetisch günstiger ist und das Handhaben der Glasplatte während des Einschmelzens des Körpers erleichtert. Letzteres ist insbesondere darin begründet, dass die Glasplatte als Ganzes noch fest und nur im Durchführbereich weich und damit verformbar ist. Der Durchführbereich kann mit einer Gasflamme oder mit einem CO₂-Laser erwärmt werden, wobei die Temperatur der Glasscheibe im Durchführbereich beispielsweise mit einem Pyrometer, Pyranometer oder einem Pyrheliometer gemessen und kontrolliert werden kann. Weiterhin hat die lokale Erwärmung des Durchführbereichs den Vorteil, dass die Vorspannung der Glasplatte erhalten bleibt.

In einer vorteilhaften Weiterentwicklung des erfindungsgemäßen Verfahrens, bei dem die Glasscheibe zwei gegenüberliegende Glasflächen aufweist, wird die Glasscheibe an beiden Glasflächen erwärmt. Aus geometrischer Sicht stellen Scheiben Körper dar, die sich dadurch auszeichnen, dass sie zwei gegenüberliegende Flächen aufweisen, die deutlich größer sind als die übrige oder übrigen Flächen. Selbiges gilt auch für die hier verwendeten Glasscheiben. Dadurch, dass beide Glasflächen gleichzeitig erwärmt werden, lässt sich einerseits die Erwärmung der Glasscheibe oder des Durchführbereiches beschleunigen und andererseits stellt sich innerhalb der Glasplatte ein gleichmäßigerer Temperaturverlauf ein. Es wird somit die Gefahr verringert, dass im Durchführbereich noch Abschnitte des Glases eine Temperatur unterhalb der Erweichungstemperatur aufweisen, was beim Durchführen des Körpers zu einer Beschädigung der Glasscheibe führen könnte.

Das erfindungsgemäße Verfahren wird dadurch weitergebildet, dass die Glasscheibe von der zweiten auf die dritte Temperatur zwangsabgekühlt wird. Einerseits lässt sich auf diese Weise der Herstellungsprozess beschleunigen, da die benötigte Zeit zum Abkühlen verringert wird. Andererseits werden mittels der Zwangsabkühlung zielgerichtet Spannungen in der Glasscheibe im Durchführbereich des eingeschmolzenen Körpers induziert, die auf diesen wirken und diesen fester mit der Glasscheibe verbinden. Eine Lockerung und ein eventuelles Herauslösen des Körpers aus der Glasscheibe werden somit weitgehend verhindert.

Das erfindungsgemäße Verfahren wird durch folgende Schritte weitergebildet:
- Erwärmen des Körpers von einer ersten Körpertemperatur auf eine zweite Körpertemperatur,
- Durchführen des Körpers durch die Glasscheibe bei der zweiten Temperatur und der zweiten Körpertemperatur, und
- Abkühlen des Körpers von der zweiten Körpertemperatur auf eine dritte Körpertemperatur.

In diesem Zusammenhang ist unter Körpertemperatur die Temperatur des Körpers zu verstehen, der erfindungsgemäß in die Glasscheibe eingeschmolzen wird. Ein Zusammenhang mit der Temperatur des menschlichen Körpers ist hier nicht herzuleiten. Der Begriff wird zur Unterscheidung von der Temperatur der Glasscheibe verwendet.

Die zweite Körpertemperatur kann niedriger gewählt werden als die zweite Temperatur der Glasscheibe. Dies ist dann vorteilhaft, wenn der thermische Ausdehnungskoeffizient des Materials, aus dem der Körper gefertigt ist, höher ist als der des verwendeten Glases. Beim Abkühlen wird das Glas auf den Körper aufgeschrumpft, so dass Spannungen in der Glasscheibe induziert werden, die auf den Körper im abgekühlten Zustand wirken und diesen in der Glasscheibe halten.

Andererseits kann die zweite Körpertemperatur höher gewählt werden als die zweite Temperatur der Glasscheibe. Dies ist dann vorteilhaft, wenn der thermische Ausdehnungskoeffizient des Materials, aus dem der Körper gefertigt ist, niedriger ist als der des Glases. Beim Abkühlen wird das Glas auf den Körper aufgeschrumpft, so dass Spannungen in der Glasscheibe induziert werden, die auf den Körper im abgekühlten Zustand wirken und diesen in der Glasscheibe halten.

In beiden Fällen ist zu berücksichtigen, dass sich sämtliche Dimensionen eines Körpers bei einer Temperaturänderung proportional zueinander ändern. Somit verringert sich beispielweise der Durchmesser eines Lochs, welches durch das Durchführen des Körpers durch die Glasscheibe erzeugt wird, beim Abkühlen im selben Verhältnis wie die übrigen Abmessungen der Glasscheibe, wodurch Spannungen erzeugt werden können, die auf den Körper wirken und diesen in der Glasscheibe fixieren.

Weiterhin kann das Verfahren dahingehend weitergebildet werden, dass der Körper von der zweiten auf die dritte Körpertemperatur zwangsgekühlt wird. Auch dadurch lassen sich der Fertigungsprozess beschleunigen und zielgerichtete Spannungen innerhalb der Glasplatte induzieren. Die Abkühlung kann auf jede geeignete Weise durchgeführt werden, beispielsweise durch Abblasen mit Pressluft oder indem die Glasscheibe durch eine Kühlkammer geführt wird.

Die Erfindung wird im Folgenden anhand von bevorzugten Ausführungsbeispielen unter Bezugnahme auf die anhängenden Figuren näher erläutert. Es zeigen
- Figur 1: eine Schnittdarstellung durch ein erstes Ausführungsbeispiel eines erfindungsgemäßen Solarmoduls,
- Figur 2: eine Schnittdarstellung durch ein zweites Ausführungsbeispiel des erfindungsgemäßen Solarmoduls,
- Figur 3: eine Schnittdarstellung durch ein drittes Ausführungsbeispiel des erfindungsgemäßen Solarmoduls und

- Figur 4: eine Schnittdarstellung durch ein viertes Ausführungsbeispiel des erfindungsgemäßen Solarmoduls.

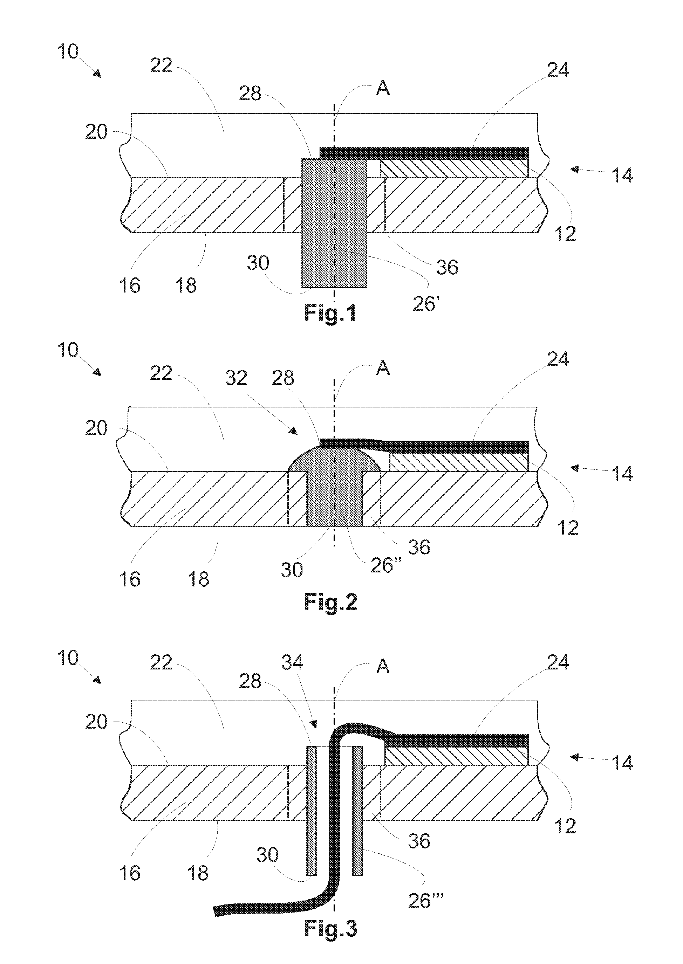

In Figur 1 ist ein erstes Ausführungsbeispiel eines erfindungsgemäßen Solarmoduls 10 in einer Schnittdarstellung gezeigt. Das Solarmodul 10 umfasst eine Solarzelle 12, welche in einer Einkapselung 14 angeordnet ist. Aus Gründen der Übersichtlichkeit ist nur eine Solarzelle 12 dargestellt, wobei aber das Solarmodul 10 eine beliebige Anzahl von Solarzellen umfassen kann. In diesem Zusammenhang ist die Zusammenfassung von 60 oder 72 Solarzellen zu einem String bestehend aus 6 x 10 oder 6 x 12 Solarzellen häufig anzutreffen.

Im dargestellten Ausführungsbeispiel umfasst die Einkapselung 14 eine Glasscheibe 16 mit einer ersten Glasfläche 18 und einer zweiten Glasfläche 20 sowie eine Schicht 22 aus Einbettungsmaterial. Die Einkapselung 14 kann auch noch eine weitere Glasscheibe 16 oder eine Folie umfassen. Im dargestellten Beispiel soll die Strahlungsenergie mittels Strahlen auf die Solarzelle 12 treffen, welche die Glasscheibe 16 von der ersten Glasfläche 18 zur zweiten Glasfläche 20 durchlaufen. Entsprechend ist die Solarzelle 12 bündig an der zweiten Glasfläche 20 der Glasscheibe 16 angeordnet, damit die Strahlen einen möglichst kurzen und damit verlustärmeren Weg durch das Solarmodul 10 zurücklegen müssen, um auf die Solarzelle 12 zu treffen.

Die Solarzelle 12 kann aus jedem geeigneten Material aufgebaut sein, beispielsweise amorphes oder kristallines Silizium. Auf der der Glasscheibe 16 abgewandten Seite der Solarzelle 12 ist ein elektrischer Leiter 24 mit der Solarzelle 12 verbunden, der die von ihr erzeugte elektrische Energie ableitet. Der elektrische Leiter 24 kann beispielsweise als Lötband ausgeführt sein. Der elektrische Leiter 24 ist leitend, etwa durch eine Lötung, mit einem Körper 26' verbunden, der in die Glasscheibe 16 eingeschmolzen ist. Im Ausführungsbeispiel, welches in Figur 1 dargestellt ist, ist der Körper 26' im Wesentlichen quaderförmig oder zylinderförmig ausgebildet, und weist ein inneres Ende 28 und ein äußeres Ende 30 auf. Die geometrische Form des Körpers 26' kann beliebig gewählt werden. Der Körper 26' durchtritt die Glasscheibe 16, so dass an einem äußeren Ende 30 des Körpers 26' weitere Leitungen angeschlossen werden können (nicht gezeigt), um die Solarzelle oder das Solarmodul 10 in einen Schaltkreis zu integrieren.

Im dargestellten Ausführungsbeispiel wird die elektrische Energie auf der Seite des Solarmoduls 10 abgeleitet, die der Strahlenquelle, typischerweise die Sonne, zugewandt ist. Üblicherweise wird die elektrische Energie auf der Seite abgeleitet, welche der Sonne abgewandt ist. Das erfindungsgemäße Prinzip ist nicht auf eine Seite des Solarmoduls 10 beschränkt und beliebig auf die eine oder andere oder auf beide Seiten anwendbar. Weiterhin ist die Solarzelle 12 auf ihrer der Sonne abgewandten Seite von der Schicht 22 aus Einkapselungsmaterial bedeckt. Es ist aber genauso gut möglich, die Schicht 22 mit einer Dicke herzustellen, die derjenigen der Solarzelle 12 entspricht, so dass sie bündig mit der Solarzelle 12 abschließt. In diesem Fall wäre die Solarzelle 12 nur stirnseitig von der Schicht 22 aus Einkapselungsmaterial umgeben.

Der Körper 26' steht auf beiden Seiten über die Glasscheibe 16 über. Er kann aber auch so ausgestaltet sein, dass er an einer oder beiden Seiten mit den Glasflächen 18, 20 der Glasscheibe 16 bündig abschließt. Insbesondere wird damit vermieden, dass der Körper 26' im Bereich des äußeren Endes 30 mit Gegenständen kollidiert, die sich in der Umgebung des Solarmoduls 10 befinden. Derartige Kollisionen können zu einer Lockerung des Körpers 26' oder zu einer Beschädigung der Glasscheibe 16 und damit des Solarmoduls 10 führen.

In Figur 2 ist ein zweites Ausführungsbeispiel des erfindungsgemäßen Solarmoduls 10 dargestellt. Der Aufbau gleicht im Wesentlichen dem ersten Ausführungsbeispiel, welches in Figur 1 beschrieben ist. Im Gegensatz zu dem in Figur 1 dargestellten Ausführungsbeispiel ist hier jedoch der Körper 26" als Bolzen mit einem Kopf 32 ausgestaltet. Der Kopf 32 dient als Anschlag, so dass die Position des Körpers 26" in Bezug auf die Glasscheibe 16 beim Einschmelzen besser festgelegt werden kann. In diesem Ausführungsbeispiel schließt das äußere Ende 30 bündig mit der ersten Glasfläche 18 ab. Der elektrische Leiter 24 ist am Kopf 32 mit dem Körper 26" verbunden.

Im dritten Ausführungsbeispiel des erfindungsgemäßen Solarmoduls 10, welches in Figur 3 dargestellt ist, weist der Körper 26'" eine Durchgangsbohrung 34 auf, durch welche der elektrische Leiter 24 geführt werden kann. In diesem Fall muss der Körper 26"' nicht aus elektrisch leitendem Material gefertigt sein, ferner muss der elektrische Leiter 24 nicht mit dem Körper 26'" leitend verbunden werden.

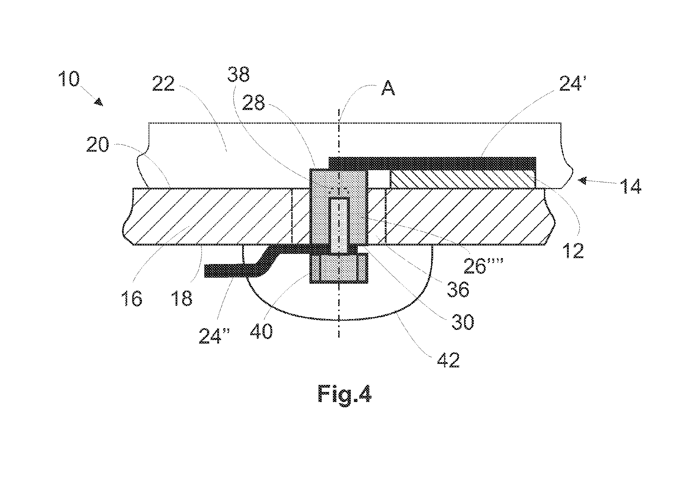

In Figur 4 ist ein viertes Ausführungsbeispiel des erfindungsgemäßen Solarmoduls 10 dargestellt. Hierbei ist der Körper 26"" mit einem Gewinde 38 versehen, in welches eine Schraube 40 von der ersten Glasfläche 18 her, also von der Vorderseite des Solarmoduls, auf welche die Strahlen treffen, eingeschraubt werden kann. Der elektrische Leiter 24 ist in einen ersten Abschnitt 24' und einen zweiten Abschnitt 24" unterteilt, wobei der erste Abschnitt 24' in der Einkapselung 14 angeordnet ist und mit der Solarzelle 12 verbunden ist. Der zweite Abschnitt 24" des elektrischen Leiters 24 kann eine Flachsteckzunge umfassen und mithilfe der Schraube 40 mit dem Körper 26"" leitend verbunden werden. Um den Körper 26"", den zweiten Abschnitt 24" des elektrischen Leiters 24 sowie die elektrisch leitende Verbindung zwischen dem Körper 26"" und dem zweiten Abschnitt 24" des elektrischen Leiters 24 vor äußeren Einflüssen wie Schneelasten zu schützen und abzudichten, ist vorzugsweise eine weitere Einkapselung 42 vorgesehen. Ferner wird ein Lockern der Schraube 40 im Betrieb des Solarmoduls 10 verhindert.

In allen drei Ausführungsbeispielen ist der Körper 26 in einem Durchführbereich 36 angeordnet. Das Zentrum dieses Durchführbereichs 36 kann mit einer Längsachse A des Körpers 26 übereinstimmen. Je nach verwendetem Verfahren wird die Glasscheibe 16 nur im Durchführbereich 36 erwärmt und der Körper 26 innerhalb dieses Durchführbereichs 36 durch die Glasscheibe 16 geführt.

Die Erfindung ist anhand von bevorzugten Ausführungsbeispielen exemplarisch beschrieben worden. Sich für den Fachmann aus der Beschreibung in naheliegender Weise ergebende Modifikationen oder Variationen, etwa betreffend den Aufbau des Solarmoduls oder des Körpers, gehen nicht über die erfindungsgemäße Idee hinaus und sind vom Schutzumfang umfasst, der durch die anhängenden Ansprüche definiert wird.

### Bezugszeichenliste

- 10: Solarmodul
- 12: Solarzelle
- 14: Einkapselung
- 16: Glasscheibe
- 18: erste Glasfläche

- 20: zweite Glasfläche
- 22: Schicht
- 24: elektrischer Leiter
- 26', 26", 26"', 24"": Körper
- 28: inneres Ende

- 30: äußeres Ende
- 32: Kopf
- 34: Durchgangsbohrung
- 36: Durchführbereich
- 38: Gewinde
- 40: Schraube
- 42: weitere Einkapselung

- A: Achse
- T₁: rste Temperatur
- T₂: zweite Temperatur
- T₃: dritte Temperatur

- T_{K1}: erste Körpertemperatur
- T_{K2}: zweite Körpertemperatur
- T_{K3}: dritte Körpertemperatur

## Patentansprüche

1. Solarmodul zum Umwandeln von Strahlungsenergie, insbesondere von Sonnenlicht, in elektrische Energie, umfassend
- eine Solarzelle (12) zum Umwandeln von Strahlungsenergie in elektrische Energie,
- einen elektrischen Leiter (24) zum Leiten der elektrischen Energie und
- eine die Solarzelle (12) umgebende Einkapselung (14) zum Schützen der Solarzelle (12), wobei die Einkapselung (14)
- eine oder mehrere Glasscheiben (16) zum Schützen und Stabilisieren der Solarzelle (12), und
- eine Schicht (22) aus Einbettungsmaterial, in das die Solarzelle (12)
einlaminiert oder eingegossen ist, umfasst,
**gekennzeichnet durch** einen in die Glasscheibe (16) eingeschmolzenen Körper (26) zum Leiten der elektrischen Energie **durch** die Glasscheibe (16) oder zum Durchführen des elektrischen Leiters (24) **durch** die Glasscheibe (16).

2. Solarmodul nach Anspruch 1,
**dadurch gekennzeichnet, dass** der Körper (26) als ein elektrisch leitender Stift ausgeführt ist, der mit dem elektrischen Leiter (24) leitend verbunden ist.

3. Solarmodul nach Anspruch 2,
**dadurch gekennzeichnet, dass** der Stift als Zylinderstift, Kegelstift oder Bolzen mit Kopf (32) ausgeführt ist.

4. Solarmodul nach einem der vorherigen Ansprüche
**dadurch gekennzeichnet, dass** der Körper (26) eine Durchgangsbohrung (34) zum Durchführen des elektrischen Leiters (24) durch den Körper (26) und durch die Glasscheibe (16) aufweist.

5. Solarmodul nach einem der Ansprüche 1 bis 3,
**dadurch gekennzeichnet, dass** der Körper (26) ein Gewinde (38) umfasst, in welches eine Schraube (40) zum elektrisch leitenden Verbinden des elektrischen Leiters (24) mit dem Körper (26) einschraubbar ist.

6. Solarmodul nach Anspruch 5,
**gekennzeichnet durch** eine weitere Einkapselung (42) zum Schützen des elektrischen Leiters (24) und Sichern der Schraube (40).

7. Solarmodul nach Anspruch 1,
**dadurch gekennzeichnet, dass** der Körper (26) aus nicht leitendem Material besteht und eine Durchgangsbohrung (34) zum Durchführen des elektrischen Leiters (24) durch den Körper (26) und durch die Glasscheibe (16) aufweist.

8. Verfahren zum Einschmelzen eines Körpers (26) in eine Glasscheibe (16) eines Solarmoduls (10) nach einem der vorherigen Ansprüche, wobei der Körper (26) zum Leiten der elektrischen Energie durch die Glasscheibe (16) dient, umfassend folgende Schritte:
- Erwärmen der Glasscheibe (16) von einer ersten Temperatur (T₁) auf eine zweite Temperatur (T₂), wobei die zweite Temperatur (T₂) gleich der oder größer als die Glasübergangstemperatur des verwendeten Glases ist,
- Durchführen des Körpers (26) durch die Glasscheibe (16) bei der zweiten Temperatur (T₂), und
- Abkühlen der Glasscheibe (16) auf eine dritte Temperatur (T₃).

9. Verfahren nach Anspruch 6,
**dadurch gekennzeichnet, dass** die Glasscheibe (16) in einem Durchführbereich (36) erwärmt wird, innerhalb dessen der Körper (26) durch die Glasscheibe (16) durchgeführt wird.

10. Verfahren nach Anspruch 6 oder 7, wobei die Glasscheibe (16) eine erste Glasfläche (18) und eine zweite, der ersten gegenüberliegende Glasfläche (20) aufweist,
**dadurch gekennzeichnet, dass** die Glasscheibe (16) an beiden Glasflächen (18, 20) erwärmt wird.

11. Verfahren nach einem der Ansprüche 6 bis 8,
**dadurch gekennzeichnet, dass** die Glasscheibe (16) von der zweiten (T₂) auf die dritte Temperatur (T₃) zwangsabgekühlt wird.

12. Verfahren nach einem der Ansprüche 6 bis 9, weiterhin umfassend folgende Schritte:
- Erwärmen des Körpers (26) von einer ersten Körpertemperatur (T_{K1}) auf eine zweite Körpertemperatur (T_{K2}),
- Durchführen des Körpers (26) durch die Glasscheibe (16) bei der zweiten Temperatur (T₂) und der zweiten Körpertemperatur (T_{K2}), und
- Abkühlen des Körpers (26) von der zweiten Körpertemperatur (T_{K2}) auf eine dritte Körpertemperatur (T_{K3}).

13. Verfahren nach Anspruch 10,
**dadurch gekennzeichnet, dass** die zweite Körpertemperatur (T_{K2}) höher als die zweite Temperatur (T₂) ist.

14. Verfahren nach Anspruch 10 oder 11,
**dadurch gekennzeichnet, dass** der Körper (26) von der zweiten Körpertemperatur (T_{K2}) auf die dritte Körpertemperatur (T_{K3}) zwangsgekühlt wird.
